# EUROPÄISCHE PATENTANMELDUNG

(11) **EP 1 981 325 A2**
(43) Veröffentlichungstag der Anmeldung: **15.10.2008**
(21) Anmeldenummer: 08101931.7
(22) Anmeldetag: 25.02.2008
(51) Int. Cl.: H05K 13/02, H05K 13/04

(54) **Zuführung von Flächenmagazinen mittels einer Transportstrecke eines Leiterplatten-Transportsystems mit mehreren Transportstrecken**

(30) Priorität: 12.04.2007 DE 102007017258
(71) Anmelder: SIEMENS AKTIENGESELLSCHAFT, 80333 München (DE)
(72) Erfinder: Dietrich, Stefan, 76149, Karlsruhe (DE); Raabe, Martin, 76646, Bruchsal (DE); Stützer, Roland, 64653, Lorsch (DE)
(74) Vertreter: Maier, Daniel Oliver

(57) **Zusammenfassung**

Es wird eine Vorrichtung (110) zum Bestücken von Bauelementeträgern (102) mit Bauteilen beschrieben. Die Vorrichtung (110) weist auf eine erste Transportstrecke (121), eingerichtet zum Transportieren eines ersten Bauelementeträgers (102) in einen ersten Bestückbereich (122), eine zweite Transportstrecke (131), eingerichtet zum Transportieren eines zweiten Bauelementeträgers in einen zweiten Bestückbereich (132), und einen Bestückkopf (136), welcher derart verfahrbar ist, dass zumindest die beiden Bestückbereiche (122, 132) erreichbar sind. Die zweite Transportstrecke (131) ist ferner derart eingerichtet, dass in Flächenmagazinen (104) aufbewahrte Bauteile in den zweiten Bestückbereich (132) zuführbar sind. Es wird ferner ein Bestücksystem (100) beschrieben, welches zumindest eine Bestückvorrichtung (110) des oben genannten Typs aufweist. Außerdem wird ein Verfahren zum Bestücken von Bauelementeträgern (102) mit Bauteilen angegeben, welche in einem Flächenmagazin (104) bereitgehalten werden. Dabei wird eine Bestückvorrichtung (110) des oben beschriebenen Typs verwendet.

## Beschreibung

Die vorliegende Erfindung betrifft das Gebiet der automatischen Bestückung von Bauelementeträgern mit elektronischen Bauelementen. Die vorliegende Erfindung betrifft insbesondere die Zuführung von Flächenmagazinen, in denen jeweils eine Vielzahl von elektronischen Bauelementen abgelegt ist, für einen Bestückautomaten, so dass die Bauelemente von einem Bestückkopf des Bestückautomaten aus dem jeweiligen Flächenmagazin entnommen und in bekannter weise auf einen zu bestückenden Bauelementeträger aufgesetzt werden können.

Die Bestückung von Bauelementeträgern bzw. Leiterplatten mit elektronischen Bauelementen erfolgt üblicherweise mittel sog. Bestückautomaten. Dabei werden die Bauelemente von einer Bauelement-Zuführeinrichtung an bestimmten Abholpositionen bereitgestellt und von dort von einem Bestückkopf abgeholt. Der Bestückkopf kann eine oder auch mehrere Bauelement-Haltevorrichtungen aufweisen, so dass gleichzeitig ein oder mehrere Bauelemente transportiert werden können. Der Bestückkopf kann mittels eines Positioniersystems innerhalb eines vorgegebenen Arbeitsbereiches positioniert werden. Nach dem Abholen werden die Bauelemente von dem Bestückkopf zu einer Bestückposition transportiert und auf dem zu bestückenden Substrat an durch entsprechende Anschlussflächen definierte Einbaupositionen aufgesetzt.

Das Zuführen der elektronischen Bauelemente für einen Bestückprozess kann auf verschiedene Arten erfolgen. So können beispielsweise Bauelemente, die in Taschen von so genannten Bauelement-Gurten verpackt sind, durch ein schrittweises Abwickeln eines Bauelement-Gurtes zeitlich nacheinander an einer vorgegebenen Abholposition bereitgestellt werden.

Außerdem können Bauelemente, die in einem Flächenmagazin aufbewahrt werden, durch ein einfaches Bereitstellen des Flächenmagazins in einem Bereich neben dem eigentlichen Bestückfeld eines Bestückautomaten dem Bestückprozess zugeführt werden. In diesem Fall werden die einzelnen elektronischen Bauelemente von dem Bestückkopf des Bestückautomaten jeweils an einer anderen Abholposition aufgenommen. Die Bereitstellung von Bauelementen mittels eines geeigneten Flächenmagazins hat den Vorteil, dass im Vergleich zu einer Bereitstellung mittels eines Bauelement-Gurtes deutlich weniger Abfall produziert wird. Anders als die entleerten Bauelement-Gurte können die Flächenmagazine nämlich unter Umständen sogar wieder verwendet werden. Dies ist bei einem Gurt nicht möglich, der beim Zuführen üblicherweise sukzessive in einzelne Gurtstücke geschnitten wird.

Aus der US 5,625,941 ist eine Flächenmagazin-Zuführvorrichtung bekannt, welche ein ausziehbares Schubladensystem und einen entsprechenden Antrieb aufweist, so dass ein mit elektronischen Bauelementen befülltes Flächenmagazin zwischen einer Ausgangsposition und einer Entnahmeposition horizontal verschiebbar ist. Die Verschiebung erfolgt dabei senkrecht zu einer Transportrichtung eines Transportsystems, mit dem Leiterplatten in den Bestückbereich eines Bestückautomaten eingeschleust und nach einer zumindest teilweisen Bestückung mit Bauelementen wieder ausgeschleust werden. In der Entnahmeposition befindet sich das Flächenmagazin zumindest teilweise oberhalb des Transportsystems, so dass der Bestückkopf beim Bestücken einer Leiterplatte nur relativ kurze Verfahrwege zurücklegen muss.

Aus der JP 2005347317 A ist ein Bestücksystem bekannt, welches neben einem Zuführsystem für eine Mehrzahl von Bauelement-Gurte, in denen jeweils ein Typ von Bauelement aufbewahrt ist, zwei Flächenmagazin-Zuführvorrichtungen aufweist. Die Flächenmagazin-Zuführvorrichtungen stellen jeweils ein Shuttle-System dar, mit dem ein Flächenmagazin zwischen einer Flächenmagazin-Speichervorrichtung und einem Entnahmebereich transferiert werden kann. Der Transfer erfolgt dabei senkrecht zu der Transportrichtung eines Transportsystems, mit dem Leiterplatten in einen Bestückbereich des Bestücksystems eingeschleust und nach einer zumindest teilweisen Bestückung mit Bauelementen wieder ausgeschleust werden.

Aus der EP 883 333 B1 ist ein Bestückautomat zum Verarbeiten von in Flächenmagazinen aufbewahrten Bauelementen bekannt. Der Bestückautomat weist ein Flächenmagazin-Zuführsystem auf, mit dem Flächenmagazine in einen Bauelement-Aufnahmebereich eingefahren werden können. Der Bauelement-Aufnahmebereich befindet sich zwischen einem Bestückbereich, in dem sich die zu bestückende Leiterplatte befindet, und einem Bauelement-Zuführsystem. Das Bauelement-Zuführsystem umfasst eine Mehrzahl von Zuführvorrichtungen, mit denen jeweils in einem Bauelement-Gurt aufbewahrte Bauelemente an einer Abholposition bereit gestellt werden. Der Bestückkopf ist derart positionierbar, dass sowohl Bauelemente von den Abholpositionen als auch aus einem entsprechend positionierten Flächenmagazin entnommen werden können. Das Flächenmagazin-Zuführsystem weist eine vertikal verschiebbare Speichereinrichtung auf, aus der mittels eines Transportmechanismus in einer horizontalen Verschieberichtung aus einem Stapel von verschiedenen Flächenmagazinen jeweils ein Flächenmagazin in den Bauelement-Aufnahmebereich ausgeschleust werden kann. Dieser Bestückautomat hat den Nachteil, dass die Abholpositionen des Bauelement-Zuführsystems und der Bestückbereich relativ weit voneinander beabstandet sind. Damit verlängern sich die erforderlichen Verfahrwege des Bestückkopfes, so dass die Effizienz des gesamten Bestückungsprozesses entsprechend reduziert wird.

Der Erfindung liegt die Aufgabe zugrunde, eine Bestückvorrichtung anzugeben, bei der Flächenmagazine für einen Bestückungsprozess auf einfache und effiziente Weise bereitgestellt werden können.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird eine Vorrichtung zum Bestücken von Bauelementeträgern mit Bauteilen beschrieben. Die beschriebene Bestückvorrichtung weist auf (a) eine erste Transportstrecke, eingerichtet zum Transportieren eines ersten Bauelementeträgers in einen ersten Bestückbereich, (b) eine zweite Transportstrecke, eingerichtet zum Transportieren eines zweiten Bauelementeträgers in einen zweiten Bestückbereich, und (c) einen Bestückkopf, welcher derart verfahrbar ist, dass zumindest die beiden Bestückbereiche erreichbar sind. Die zweite Transportstrecke ist ferner derart eingerichtet, dass in Flächenmagazinen aufbewahrte Bauteile in den zweiten Bestückbereich zuführbar sind.

Der beschriebenen Bestückvorrichtung liegt die Erkenntnis zugrunde, dass ein bekanntes Leiterplatten-Doppel-Transportsystem, wie es z.B. in der Schrift DE 199 25 217 A1 beschrieben und welches üblicherweise für sog. Hochleistungsbestückautomaten verwendet wird, auf einfache Weise derart modifiziert werden kann, dass anstelle von Bauelementeträgern Flächenmagazine in den zweiten Bestückbereich eingebracht werden können. Dies bedeutet, dass der zweite Bestückbereich dahingehend zweckentfremdet wird, dass er als Entnahmebereich dient. Im Falle der Bestückung von mit einem Flächenmagazin zugeführten Bauteilen wird der Bestückkopf somit Bauteile in dem zweiten Bestückbereich aufnehmen, in den ersten Bestückbereich transportieren und auf einen dort befindlichen Bauelementträger aufsetzen.

Der Bestückkopf kann abhängig von der jeweiligen Anforderung ein Einfach-Bestückkopf oder auch ein Mehrfach-Bestückkopf sein. Mit einem Mehrfach-Bestückkopf können mehrere Bauteile bevorzugt sequentiell aufgenommen, gleichzeitig transportiert und bevorzugt sequentiell auf dem Bauelementträger aufgesetzt werden.

Es wird darauf hingewiesen, dass die Erfindung keineswegs auf die Verwendung eines Doppel-Transportsystems beschränkt ist. Die Verwendung einer Transportstrecke bzw. einer Transportspur zum Zwecke einer bestücknahen Bereitstellung von Flächenmagazinen kann selbstverständlich auch bei Transportsystemen erfolgen, welche drei oder sogar mehr als drei Transportstrecken aufweisen.

Unter dem Begriff Bauteil werden im Folgenden alle bestückfähigen Elemente verstanden, insbesondere elektronische Bauelemente, elektromechanische Bauelemente, Stecker und Steckverbindungen für elektrische und mechanische Kontakte sowie Abschirmbleche. Der Begriff Bauteil kann jedoch auch Werkzeuge, Hilfsmittel oder beliebige Sonderkonstruktionen umfassen, welche bei der Bestückung von elektronischen Bauelementen behilflich sind. Werkzeuge sind beispielsweise Saugpipetten zum temporären Aufnehmen von Bauelementen oder sog. Dip-Einrichtungen, mit denen eine Unterseite eines Bauteils beispielsweise mit einem Klebstoff oder mit einem zunächst noch zähflüssigen Underfill-Material benetzt wird. Hilfsmittel oder Sonderkonstruktionen sind beispielsweise Wannen oder Rahmen, die zum präzisen Platzieren einer Flachbaugruppe verwendet werden können.

Die beschriebene Verwendung zumindest eines Teiles einer Transportspur eines Doppel-Transportsystems für Leiterplatten als Zuführeinrichtung für Flächenmagazine hat den Vorteil, dass zur Zuführung von Flächenmagazinen keine spezielle Flächenmagazin-Zuführvorrichtung erforderlich ist, um in Flächenmagazinen bereitgestellte Bauteile verarbeiten zu können. Dies hat zur Folge, dass ausgehend von einem bekannten Bestückautomaten mit einem Doppel-Transportsystem für Leiterplatten die beschriebene Bestückvorrichtung auf einfache Weise und insbesondere ohne große Investitionskosten realisiert werden kann.

Die Verwendung einer Transportspur des Doppel-Transportsystems als Zuführeinrichtung für Flächenmagazine hat ferner den Vorteil, dass der gesamte verfügbare Durchfahrbereich einer Leiterplatten-Transportstrecke ausgenutzt werden kann. Auf diese Weise können problemlos elektronische Bauelemente, Werkstücke oder andere für einen Bestückvorgang geeignete Werkzeuge zugeführt werden, die mit anderen Zuführsystemen aufgrund Größe oder Bauform der entsprechenden Bauteile nicht verarbeitet werden können.

Gemäß einem Ausführungsbeispiel der Erfindung nach Anspruch 2 verlaufen die beiden Transportstrecken zumindest innerhalb der jeweiligen Bestückbereiche parallel zueinander.

Im Gegensatz zu bekannten Flächenmagazin-Zuführvorrichtungen, bei denen das Flächenmagazin senkrecht zu der Transportrichtung der zu bestückenden Leiterplatte an den Bestückbereich herangefahren wird, hat die parallele Führung der beiden Transportstrecken den Vorteil, dass auch die Flächenmagazine auf effektive Weise in den zweiten Bestückbereich bzw. in den Entnahmebereich eingefahren und herausgefahren werden können. Dabei kann ein Flächenmagazin von einer ersten Seite in den Entnahmebereich eingefahren und über eine gegenüberliegende zweite Seite aus dem Entnahmebereich herausgefahren werden. Dabei kann gleichzeitig mit dem Herausfahren des Flächenmagazins bereits ein nächstes Flächenmagazin in den Entnahmebereich eingefahren werden. Dies ermöglicht einen besonders schnellen Austausch von Flächenmagazinen, so dass die mit dem Austausch verbundene Zeitspanne, in der keine Bauteile entnommen werden können, besonders kurz ist. Bei einem Wechsel von Flächenmagazinen muss der Bestückvorgang demzufolge nicht oder nur sehr kurz unterbrochen werden.

Im Vergleich zu den o. g. bekannten Flächenmagazin-Zuführvorrichtungen, bei denen das Einfahren und das Herausfahren der Flächenmagazine auf dem gleichen Abschnitt einer Transportstrecke erfolgt, kann bei der hiermit beschriebenen Vorrichtung sowohl das Einfahren als auch das Ausfahren in der selben Transportrichtung erfolgen. Somit ist es ausreichend, wenn das zweite Transportsystem lediglich für einen Flächenmagazin-Transport entlang einer Transportrichtung eingerichtet ist.

Gemäß einem weiteren Ausführungsbeispiel der Erfindung nach Anspruch 3 ist die zweite Transportstrecke ferner derart eingerichtet, dass Flächenmagazine wahlweise in einer ersten Transportrichtung oder in einer zweiten Transportrichtung transportierbar sind. Dabei sind die beiden Transportrichtungen zueinander antiparallel orientiert, so dass die zweite Transportstrecke einen Flächenmagazin-Transport entlang zueinander entgegen gesetzter Richtungen ermöglicht.

Sofern die zweite Transportstrecke die Aufnahme mehrerer Flächenmagazine mit ggf. unterschiedlichen Bauteilen erlaubt, können durch eine gezielte Verfahrbewegung des zweiten Transportsystems, welche eine Vorwärts- und eine Rückwärtsbewegung umfasst, unterschiedliche Bauteile aus unterschiedlichen Flächenmagazinen in einer beliebigen Reihenfolge in dem Entnahmebereich bereit gestellt werden. Dabei bestimmt neben der Größe der einzelnen Flächenmagazine die Länge der zweiten Transportstrecke, wie viele Flächenmagazine von der zweiten Transportstrecke aufgenommen und bei Bedarf in dem zweiten Bestückbereich bzw. in dem Entnahmebereich bereitgestellt werden können.

Gemäß Anspruch 4 weist die Bestückvorrichtung zusätzlich ein Positioniersystem zum Verfahren des Bestückkopfes auf. Das Positioniersystem ist dabei bevorzugt ein Flächenpositioniersystem, mit dem der Bestückkopf innerhalb einer horizontalen xy-Ebene frei positioniert werden kann.

Damit können von dem Bestückkopf Bauteile aus jedem Fach bzw. jedem Bereich des Flächenmagazins entnommen und an beliebigen Positionen innerhalb des ersten Bestückbereichs auf einem Bauelementeträger aufgesetzt werden.

Es wird darauf hingewiesen, dass auch die Verwendung eines linearen Positioniersystems denkbar ist. In diesem Fall kann relativ zu dem Flächenmagazin bzw. zu dem zu bestückenden Bauelementeträger eine zweidimensionale Relativbewegung des Bestückkopfes dadurch realisiert werden kann, dass (a) eine eindimensionale Bewegung des Flächenmagazins bzw. des zu bestückenden Substrats entlang der jeweiligen Transportrichtung mit (b) einer eindimensionalen Bewegung des Bestückkopfs überlagert wird. Die Bewegung des Bestückkopfes erfolgt dabei winklig und insbesondere senkrecht zu der Transportrichtung. Eine derartige Bestückung wird häufig auch "On The Fly Bestückung" genannt.

Gemäß Anspruch 5 weist die Bestückvorrichtung ferner zumindest ein Bauelement-Zuführsystem auf, welches seitlich neben den beiden Transportstrecken angeordnet ist.

Das Bauelement-Zuführsystem kann eine Mehrzahl von einzelnen Bauelement-Zuführvorrichtungen aufweisen, mit denen jeweils ein Typ von elektronischem Bauelement an eine Abholposition bereitgestellt werden kann. Dies kann in bekannter Weise durch die Verwendung von Bauelement-Gurten realisiert werden. Selbstverständlich ist es für eine Verarbeitung bzw. für eine Bestückung von mit dem Bauelement-Zuführsystem bereitgestellten Bauelementen erforderlich, dass der Verfahrbereich des Bestückkopfs bis hin zu den jeweiligen Abholpositionen reicht.

Die beschriebene Bestückvorrichtung hat den Vorteil, dass sowohl Bauteile aus Flächenmagazinen als auch Bauelemente aus Bauelement-Gurten dem Bestückprozess zur Verfügung gestellt werden können. Dabei ist in vorteilhafter Weise eine spezielle Zuführeinrichtung für Flächenmagazine entbehrlich, so dass der Platz seitlich neben den beiden Transportspuren ohne Einschränkung für herkömmliche Bauelement-Zuführsysteme verwendet werden kann. Dies gilt für beide Seiten neben den zwei Transportstrecken. Somit können beispielsweise konventionelle Bauelementgurt-Zuführvorrichtungen in herkömmlicher Weise auf beiden Seiten der Transportstrecken angeordnet werden. Dies erhöht die Flexibilität der beschriebenen Bestückvorrichtung in Hinblick auf unterschiedliche Bestückungsaufgaben, da ein größeres Spektrum an unterschiedlichen Bauteilen bzw. Bauelementen bereitgestellt werden kann.

Gemäß Anspruch 6 weist die Bestückvorrichtung ferner einen weiteren Bestückkopf auf, welcher derart verfahrbar ist, dass zumindest der erste Bestückbereich und das Bauelement-Zuführsystem erreichbar sind. Dies hat den Vorteil, dass bei einer geeigneten Steuerung der Bewegungen der beiden Bestückköpfe ein wechselweise durchgeführtes Bestücken einer Leiterplatte und Aufnehmen von Bauelementen möglich ist. Dies bedeutet, dass gerade dann, wenn (a) zumindest ein Bauteil von dem Bestückkopf aus einem im zweiten Bestückbereich eingebrachten Flächenmagazin entnommen wird, (b) zumindest ein Bauelement, welches bereits zuvor von dem weiteren Bestückkopf aus dem Bauelement-Zuführsystem entnommen wurde, auf einen im ersten Bestückbereich befindlichen Bauelementeträger aufgesetzt wird. In entsprechender Weise wird gerade dann, wenn (a) ein bereits zuvor von dem Bestückkopf aus dem Flächenmagazin entnommenes Bauteil auf den Bauelementeträger aufgesetzt wird, (b) von dem weiteren Bestückkopf zumindest ein Bauelement aufgenommen, welches von dem Bauelement-Zuführsystem bereitgestellt wird.

Die Prozesssteuerung sollte dabei aus Gründen der Prozesssicherheit derart erfolgen, dass Kollisionen zwischen den beiden Bestückköpfen, die ja beide zumindest den ersten Bestückbereich erreichen können, zuverlässig ausgeschlossen sind. Die erfordert in bekannter Weise eine Synchronisation der Bewegungen der beiden Bestückköpfe.

Gemäß Anspruch 7 ist die Bestückvorrichtung derart eingerichtet ist, dass (a) Flächenmagazine manuell in die zweite Transportstrecke einlegbar sind und/oder dass (b) Flächenmagazine manuell von der zweiten Transportstrecke entnehmbar sind. Dies hat den Vorteil, dass die beschriebene Bestückvorrichtung ohne jeden apparativen Aufwand zwischen zwei einem ersten Betriebsmodus und einem zweiten Betriebsmodus umgeschaltet werden kann.

In dem ersten Betriebsmodus werden die beiden Transportstecken in bekannter Weise zur Zuführung von zu bestückenden Bauelementeträgern und zum Abführen von zumindest teilweise bestückten Bauelementeträgern verwendet. In dem zweiten Betriebsmodus wird nur die erste Transportstrecke zum Transport von Bauelementeträgern verwendet. Die zweite Transportstrecke dient, wie oben beschrieben, der Bereitstellung eines Flächenmagazins in der Nähe des ersten Bestückbereiches, in dem sich während der Bestückung der zu bestückende Bauelementeträger befindet.

In diesem Zusammenhang wird darauf hingewiesen, dass es für ein manuelles Einlegen bzw. ein manuelles Entnehmen von Flächenmagazinen erforderlich ist, dass die zweite Transportstrecke frei zugänglich ist. Dies bedeutet, dass innerhalb eines Bestücksystems, welches mehrere Bestückvorrichtungen und andere Vorrichtungen beispielsweise zum Bedrucken von Bauelementeträgern und/oder zum Verlöten von fertig bestückten Bauelementeträgern aufweisen kann, diese Vorrichtung so weit voneinander beabstandet sind, dass eine Bedienperson auf die zweite Transportstrecke zugreifen kann. Ferner sollte die zweite Transportstrecke an den entsprechenden Stellen möglichst frei von Überbauten sein, so dass die Flächenmagazine auf bequeme Weise eingelegt und/oder entnommen werden können.

Gemäß Anspruch 8 weist die Bestückvorrichtung ferner auf (a) ein mit der zweiten Transportstrecke gekoppeltes Zuführmodul zum automatischen Transferieren von Flächenmagazinen an die zweite Transportstrecke und/oder (b) ein mit der zweiten Transportstrecke gekoppeltes Entnahmemodul zum automatischen Entnehmen von Flächenmagazinen von der zweiten Transportstrecke. Dies hat den Vorteil, dass die Bereitstellung und der Abtransport der Flächenmagazine auf automatische Weise erfolgen können, ohne dass eine Bedienperson erforderlich wäre.

Im Falle der Verwendung von lediglich einer Transportrichtung für die zweiten Transportstrecke befindet sich das Zuführmodul vor (stromaufwärts) dem zweiten Bestück- bzw. Entnahmebereich und das Entnahmemodul befindet sich nach (stromabwärts) dem Entnahmebereich.

Es wird darauf hingewiesen, dass die Verwendung von lediglich einer Transportrichtung eine ggf. erforderliche Positionsjustage nicht ausschließt, bei der ein in den Entnahmebereich eingeführtes Flächenmagazin nach einem geringfügigen Überschreiten der exakten Entnahmeposition durch eine kurze präzise Verfahrbewegung in diese Entnahmeposition gebracht wird.

Die beiden Module können mit jeweils einer Speichervorrichtung zum Aufbewahren von Flächenmagazinen gekoppelt sein, so dass ein manueller Austausch von Flächenmagazinen kollektiv für eine Vielzahl von Flächenmagazinen erfolgen kann. Dies erhöht die Wirtschaftlichkeit der beschriebenen Bestückvorrichtung, da manuelle Tätigkeiten von Bedienpersonen auf ein Minimum reduziert werden.

Gemäß Anspruch 9 weist die Bestückvorrichtung ferner auf (a) eine Speichervorrichtung, welche zum Aufnehmen einer Mehrzahl von Flächenmagazinen eingerichtet ist, und (b) eine Handhabungsvorrichtung, welche sowohl mit der Speichervorrichtung als auch mit der zweiten Transportstrecke gekoppelt ist.

Dabei kann die Handhabungsvorrichtung derart ausgebildet sein, dass selektiv jeweils ein bestimmtes Flächenmagazin auf der zweiten Transportstrecke bereitstellbar ist und nach einer Entnahme von zumindest einem Bauteil wieder in der Speichervorrichtung einlagerbar ist.

Die Speichervorrichtung kann beispielsweise als Speicherturm ausgebildet sein, in dem in einer vertikalen Anordnung auf Platz sparende Weise mehrere Flächenmagazine schichtweise übereinander eingelagert werden können. Der Speicherturm kann in eine Mehrzahl von Fächern unterteilt sein, die jeweils ein Flächenmagazin aufnehmen können. Die Fächer können dabei gleich hoch sein oder auch eine unterschiedliche Höhe aufweisen, so dass auch unterschiedlich hohe Flächenmagazine auf Platz sparende Weise in dem Speicherturm eingelagert werden könne.

Mit dem Patentanspruch 10 wird ein Bestücksystem zum Bestücken von Bauelementeträgern mit Bauteilen beschrieben. Das beschriebene Bestücksystem weist zumindest eine Bestückvorrichtung des oben genannten Typs auf.

Dem beschriebenen Bestücksystem liegt die Erkenntnis zugrunde, dass die oben beschriebene Bestückvorrichtung auf vorteilhafte Weise zu einer signifikanten Erhöhung der Flexibilität einer ganzen Bestücklinie beitragen kann. Ohne die Verwendung einer speziellen Flächenmagazin-Zuführvorrichtung können somit bei Bedarf Bauteile aus einem Flächenmagazin für den Bestückungsvorgang bereitgestellt werden. Bereits vorhandene Zuführvorrichtungen - beispielsweise für in bekannter Weise in Bauelement-Gurten aufgebewahrte Bauelemente - können somit ohne Einschränkung weiter verwendet werden. Damit wird die Flexibilität des Bestücksystems insbesondere hinsichtlich der verarbeitbaren Typenvielfalt an Bauteilen erheblich erhöht. Ein zeitaufwendiger Umbau bzw. eine Umkonfigurierung der Bestücklinie im Falle von Loswechseln wird somit in der Praxis weniger oft erforderlich sein.

Die Bestücklinie kann einen oder mehrere Bestückvorrichtungen des oben genannten Typs aufweisen. Diese können innerhalb des Bestücksystems bzw. der Bestücklinie parallel oder in Serie geschaltet sein. Ferner kann das Bestücksystem andere Vorrichtungen beispielsweise (a) zum Bedrucken von Bauelementeträgern, (b) zum optischen Inspizieren von unbestückten, teilweise bestückten und/oder vollständig bestückten Bauelementeträgern und/oder (c) zum Verlöten von fertig bestückten Bauelementeträgern aufweisen.

Gemäß einem Ausführungsbeispiel der Erfindung nach Anspruch 11 weist das Bestücksystem ferner eine weitere Bestückvorrichtung des oben genannten Typs auf. Dabei bilden die erste Transportstrecke der Vorrichtung und die erste Transportstrecke der weiteren Vorrichtung eine gemeinsame erste Transportstrecke. Dies bedeutet, dass sich die erste Transportstrecke über beide Bestückvorrichtungen erstreckt, so dass nach einer teilweisen Bestückung eines Bauelementeträgers mittels der Bestückvorrichtung der Bauelementeträger direkt an die weitere Bestückvorrichtung übergeben werden kann.

Gemäß einem weiteren Ausführungsbeispiel der Erfindung nach Anspruch 12 bilden die zweite Transportstrecke der Vorrichtung und die zweite Transportstrecke der weiteren Vorrichtung eine gemeinsame zweite Transportstrecke. Dies hat den Vorteil, dass mit der zweiten Transportstrecke eine Vielzahl von verschiedenen Flächenmagazinen bewegt werden können, welche beiden Bestückvorrichtungen zugeführt werden können. Damit erhöht sich zusätzlich die Flexibilität des beschriebenen Bestücksystems, da das für beide Bestückvorrichtungen zur Verfügung stehende Bauteilspektrum erhöht wird.

In diesem Zusammenhang ist zu beachten, dass infolge der Kombination der beiden zweiten Transportstrecken die effektive Länge der zweiten Transportstrecke im Vergleich zu separaten zweiten Transportstrecken erhöht wird. Somit ist bei einer vorgegebenen Größe von Flächenmagazinen die Kapazität der zweiten Transportstrecke bezüglich der Anzahl an aufnehmbaren Flächenmagazinen erhöht.

Gemäß Anspruch 13 sind die zweite Transportstrecke der Vorrichtung und die zweite Transportstrecke der weiteren Vorrichtung voneinander getrennt. Die Trennung der beiden Transportstrecken hat zur Folge, dass die maximale Anzahl der Flächenmagazine, die einer Bestückvorrichtung zugeführt werden können, im Vergleich zu einer kombinierten zweiten Transportstrecke reduziert ist. Diese Reduzierung an Flexibilität, die zunächst nachteilig zu sein scheint, hat jedoch den Vorteil, dass die Effizienz der für jede Bestückvorrichtung einzeln durchgeführten Flächenmagazin-Zuführung erhöht wird, da infolge der reduzierten Anzahl an jeweils zur Verfügung stehenden Flächenmagazinen die Verfahrwege der Flächenmagazine kürzer werden. Damit kann ein Austausch von Flächenmagazinen in der Regel deutlich schneller durchgeführt werden, so dass die Standzeiten während eines Flächenmagazin-Wechsels, in denen keine Bauteilentnahme aus einem Flächenmagazin möglich ist, verkürzt werden können. Im Übrigen kann bei der Rüstung des Bestücksystems die Verteilung der Bauteile auf beide Bestückautomaten so gewählt werden, dass hinsichtlich des Bauteilspektrums von beiden Bestückvorrichtungen kein oder lediglich ein geringer Überlapp besteht. In diesem Fall entfällt die Notwendigkeit, sämtliche Flächenmagazine an beiden Bestückvorrichtungen bereit zu stellen.

Mit dem Patentanspruch 14 wird ein Verfahren zum Bestücken von Bauelementeträgern mit Bauteilen beschrieben, welche in einem Flächenmagazin bereitgehalten werden. Dabei wird eine Bestückvorrichtung des oben beschriebenen Typs verwendet. Das beschriebene Verfahren weist auf (a) Transportieren eines Bauelementeträgers in den ersten Bestückbereich mittels der ersten Transportstrecke, (b) Zuführen des Flächenmagazins in den zweiten Bestückbereich mittels der zweiten Transportstrecke, und (c) mittels des Bestückkopfes (c1) Aufnehmen von zumindest einem in dem Flächenmagazin aufbewahrten Bauteil, (c2) Transportieren des aufgenommenen Bauteils in den ersten Bestückbereich und (c3) Aufsetzen des Bauteils an eine vorgegebene Position auf dem Bauelementeträger.

Dem genannten Verfahren liegt die Erkenntnis zugrunde, dass ein Teil eines Leiterplatten-Transportsystems, welches zumindest zwei getrennte Zuführstrecken umfasst, als Zuführvorrichtung für Flächenmagazine verwendet werden kann. Dies bedeutet, dass anstelle eines zweiten Bauelementeträgers ein zumindest teilweise mit Bauteilen befülltes Flächenmagazin in den zweiten Bestückbereich eingeschleust wird. Der zweite Bestückbereich stellt dann für den Bestückkopf einen Entnahmebereich dar.

Insbesondere dann, wenn die beiden Transportstrecken parallel zueinander verlaufen und zudem eine geringe Beabstandung zueinander aufweisen, kann das Flächenmagazin während der Bauteilentnahme durch den Bestückkopf nahe bei dem ersten Bestückbereich angeordnet werden. Dies hat den Vorteil, dass die entsprechenden Verfahrwege des Bestückkopfes relativ kurz gehalten werden können und so die Effizienz einer Bestückung von Bauelementeträgern erhöht wird.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

Figur 1 zeigt ein Bestücksystem mit (a) einer konventionellen Bauelement-Zuführung mittels zweier seitlich angeordneter Bauelement-Zuführsysteme und mit (b) einer Flächenmagazin-Zuführung mittels einer Transportstrecke eines Doppel-Transportsystems.

Figur 2a zeigt eine Bestückvorrichtung mit einem Doppel-Transportsystem für Bauelementeträger, wobei eine Transportstrecke des Doppel-Transportsystems zum Zuführen von Flächenmagazinen verwendet wird, die manuell auf die Transportstrecke aufgelegt werden.

Figur 2b zeigt eine Bestückvorrichtung, wobei eine Transportstrecke eines Doppel-Transportsystems zum Zuführen von Flächenmagazinen verwendet wird, die mittels eines Zuführmoduls auf die Transportstrecke transferiert werden und mittels eines Entnahmemoduls von der Transportstrecke entfernt werden.

Figur 2c zeigt eine Bestückvorrichtung, wobei eine Transportstrecke eines Doppel-Transportsystems zum Zuführen von Flächenmagazinen verwendet wird, die mittels eines Zuführsystems auf die Transportstrecke transferiert werden und mittels des Zuführsystems von der Transportstrecke entfernt werden.

An dieser Stelle bleibt anzumerken, dass sich in der Zeichnung die Bezugszeichen von gleichen oder von einander entsprechenden Komponenten lediglich in ihrer ersten Ziffer unterscheiden.

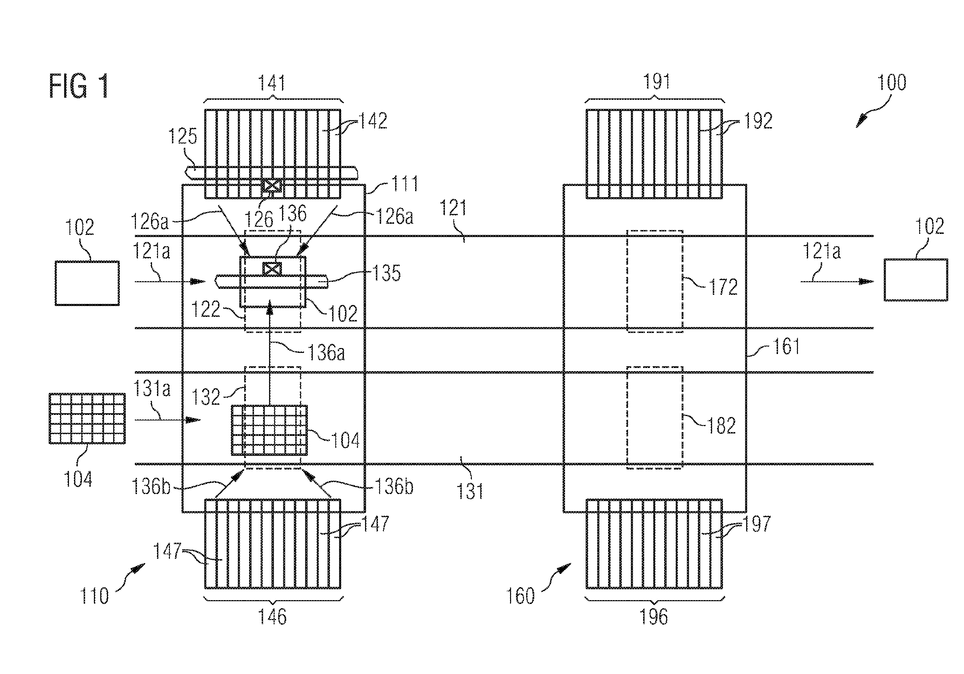

Figur 1 zeigt ein Bestücksystem 100, welches zwei Bestückautomaten, einen ersten Bestückautomaten 110 und einen zweiten Bestückautomaten 160 aufweist. Die beiden Bestückautomaten 110 und 160 sind über ein Doppel-Transportsystem für Leiterplatten bzw. für Bauelementeträger verbunden. Das Doppel-Transportsystem weist eine erste Transportstrecke 121 und eine zweite Transportstrecke 131 auf, die parallel zueinander verlaufen. Die beiden Transportstrecken 121 und 131 sind in bekannter Weise zum Transportieren von zu bestückenden Bauelementeträgern 102 eingerichtet.

Wie aus Figur 1 ersichtlich, wird gemäß dem hier dargestellten Ausführungsbeispiel der Erfindung die erste Transportstrecke 121 dazu verwendet, zu bestückende Bauelementeträger 102 entlang einer Transportrichtung 121a in einen ersten Bestückbereich 122 zu transferieren. Aus Gründen der Übersichtlichkeit nicht zusätzlich dargestellt, dient die erste Transportstrecke 121 ferner dazu, zumindest teilweise bestückte Bauelementeträger 102 wieder aus dem ersten Bestückbereich auszuschleusen und in einen stromabwärts angeordneten ersten Bestückbereich 172 des zweiten Bestückautomaten 160 zu transportieren. Nach einer weiteren Bestückung in dem Bestückbereich 172 wird der Bauelementeträger 102 entlang der Transportrichtung 121a aus dem zweiten Bestückautomaten ausgeschleust. Danach kann er in bekannter Weise beispielsweise mittels eines Reflow-Ofens verlötet werden.

Wie ferner aus Figur 1 ersichtlich, wird gemäß dem hier dargestellten Ausführungsbeispiel die zweite Transportstrecke 131 dazu verwendet, ein mit Bauteilen (nicht dargestellt) beladenes Flächenmagazin 104 in einen zweiten Bestückbereich 132 zu transferieren. Die Bauteile können von einem Bestückkopf 136, welcher mittels eines Flächenpositioniersystems 135 relativ zu einem Chassis 111 des Bestückautomaten 110 bewegt werden kann, von dem in dem zweiten Bestückbereich 132 befindlichen Flächenmagazin 104 entnommen und auf einen in dem ersten Bestückbereich 122 befindlichen Bauelementeträger 102 aufgesetzt werden. Die entsprechende Transportbewegung der Bauteile ist mit dem Bezugszeichen 136a gekennzeichnet.

Die Bestückvorrichtung 110 weist ferner zwei Bauelement-Zuführsysteme auf, die mit den Bezugszeichen 141 und 146 gekennzeichnet sind. Das Bauelement-Zuführsystem, welches sich in Transportrichtung 121a links von den beiden Transportstrecken 121, 131 befindet, weist eine Mehrzahl von Bauelement-Zuführvorrichtungen 142 auf, die in bekannter Weise jeweils zum Zuführen von in einem Bauelement-Gurt verpackten elektronischen Bauelementen vorgesehen sind. Entsprechendes gilt für das Bauelement-Zuführsystem 146, welches sich in Transportrichtung 131a rechts von den beiden Transportstrecken 121, 131 befindet und welches ebenfalls eine Mehrzahl von Bauelement-Zuführvorrichtungen 147 aufweist, die jeweils zum Zuführen von gurtverpackten Bauelementen vorgesehen sind.

Um ein effizientes Bestücken des Bauelementeträgers zu ermöglichen, weist die Bestückvorrichtung 110 zusätzlich einen Bestückkopf 126 auf, der mittels eines Flächenpositioniersystems 125 relativ zu dem Chassis 111 in einer horizontalen xy-Ebene bewegt werden kann. Wie aus Figur 1 ersichtlich, kann der Bestückkopf 126 bis in den Bereich des Bauelement-Zuführsystems 141 verfahren werden. Somit können von dem Bestückkopf 126 elektronische Bauelemente an den jeweiligen Abholpositionen der einzelnen Bauelement-Zuführvorrichtungen 142 abgeholt und nach einer Transportbewegung, die schematisch mit dem Bezugszeichen 126a dargestellt ist, auf dem in dem ersten Bestückbereich 122 befindlichen Bauelementeträger 102 aufgesetzt werden.

Um eine möglichst große Vielfalt an unterschiedlichen Bauelementen bereitstellen und für den Bestückvorgang verwenden zu können, ist gemäß dem hier dargestellten Ausführungsbeispiel der Bestückkopf 136 bis in den Bereich des Bestücksystems 146 verfahrbar. Somit können von dem Bestückkopf 136 nicht nur Bauteile aus dem im Entnahmebereich befindlichen Flächenmagazin 104 verarbeitet werden. Ebenso können von den einzelnen Bauelement-Zuführvorrichtungen 147 bereitgestellte elektronische Bauelemente aufgenommen und auf dem Bauelementeträger 102 aufgesetzt werden. Die Transportbewegung der von den Bauelement-Zuführvorrichtungen 147 bereitgestellten Bauelemente ist schematisch mit den Bewegungspfeilen 136b gekennzeichnet.

Um eine effiziente Bestückung sowohl mit Bauteilen aus dem Flächenmagazin 104 als auch mit Bauelementen, die von dem Bauelement-Zuführsystem bereitgestellt werden, zu ermöglichen, können die Bestückköpfe 126 und 136 in synchronisierter weise wechselweise zum Abholen von Bauelementen bzw. Bauteilen und zum Aufsetzen von Bauelementen bzw. Bauteilen eingesetzt werden. Dies bedeutet, dass gerade dann, wenn (a) Bauteile von dem Bestückkopf 136 aus einem in dem Bestückbereich 132 eingebrachten Flächenmagazin 104 entnommen werden, (b) Bauelemente, welche bereits zuvor von dem Bestückkopf 126 aus dem Bauelement-Zuführsystem 141 entnommen wurden, auf einen in dem Bestückbereich 122 befindlichen Bauelementeträger 102 aufgesetzt werden. In entsprechender Weise wird gerade dann, wenn (a) bereits zuvor von dem Bestückkopf 136 aus dem Flächenmagazin 104 entnommene Bauteile auf den Bauelementeträger 102 aufgesetzt werden, (b) von dem Bestückkopf 126 Bauelemente aufgenommen, die dem Bauelement-Zuführsystem 141 bereitgestellt werden.

Der zweite Bestückautomat 160, welcher in analoger Weise wie der erste Bestückautomat 110 ebenfalls ein Chassis 161, einen ersten Bestückbereich 172 und einen Entnahmebereich bzw. einen zweiten Bestückbereich 182 aufweist, kann auf die gleiche Weise zum Bestücken von Bauelementeträgern 102 betrieben werden. Demzufolge weist auch der zweite Bestückautomat 160 linksseitig ein Bauelement-Zuführsystem 191 mit einer Mehrzahl von Bauelement-Zuführvorrichtungen 192 und rechtsseitig ein Bauelement-Zuführsystem 196 mit einer Mehrzahl von Bauelement-Zuführvorrichtungen 197 auf.

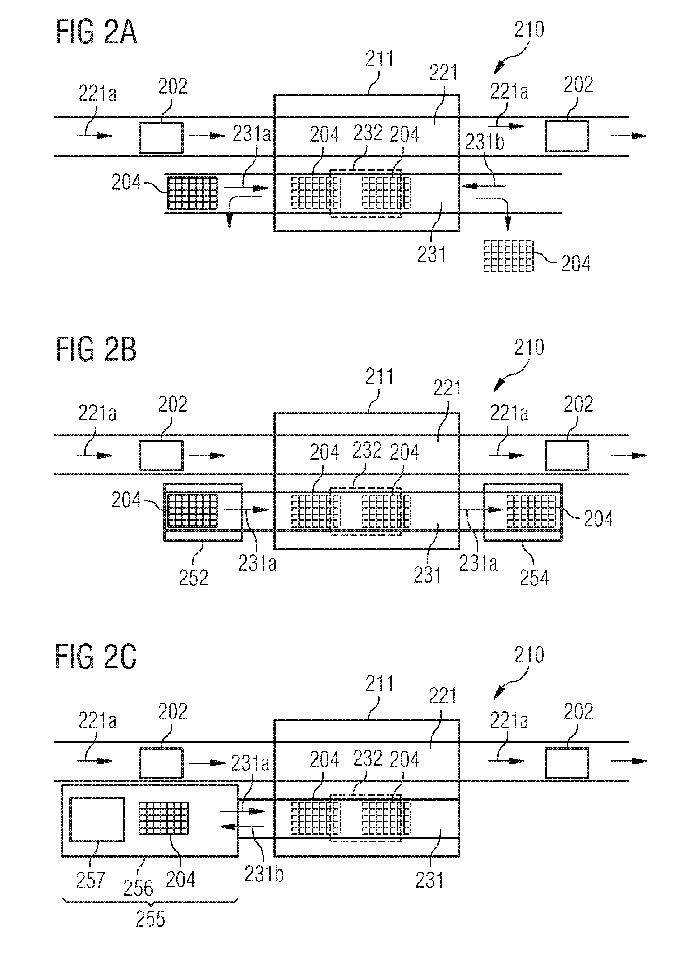

Figur 2a zeigt gemäß einem Ausführungsbeispiel der Erfindung einen Bestückautomaten 210, welche ebenfalls zum Zuführen von Flächenmagazinen 204 eingerichtet ist. Der Bestückautomat 210 weist ein Chassis 211 auf, welches von einem Bauelementeträger-Doppeltransportssystem gekreuzt wird. Das Doppeltransportssystem weist eine erste Transportstrecke 221 zum Transportieren von Bauelementeträgern 202 und eine zweite Transportstrecke 231 auf, die zum Transportieren von Flächenmagazinen 204 verwendet wird.

Der Transport der Bauelementeträger 202 erfolgt dabei entlang der Transportrichtung 221a. Der Transport der Flächenmagazine 204, welche gemäß dem hier dargestellten Ausführungsbeispiel von einer Bedienperson manuell auf die zweite Transportstrecke 231 aufgelegt werden, kann sowohl entlang der Transportrichtung 231a als auch entlang der Transportrichtung 231b erfolgen. Durch einen derartigen Wechsel der Transportrichtung 231a, 231b kann wahlweise jeweils ein ausgewähltes Flächenmagazin 204, welches sich zusammen mit anderen Flächenmagazinen 204 auf der zweiten Transportstrecke 231 befindet, in den Entnahmebereich 232 eingeschleust und nach einer Bauteilentnahme durch einen in Figur 2a nicht dargestellten Bestückkopf wieder ausgeschleust werden.

Figur 2b zeigt gemäß einem weiteren Ausführungsbeispiel der Erfindung eine Bestückvorrichtung 210. Im Gegensatz zu der in Figur 2a dargestellten Bestückvorrichtung erfolgt hier die Bereitstellung der Flächenmagazine 204 nicht manuell, sondern mittels eines Flächenmagazin-Zuführmoduls 252, welches die Flächenmagazine 204 auf der zweiten Transportstrecke 231 ablegt. Ferner ist ein Flächenmagazin-Entnahmemodul 254 vorgesehen, welches nach einer zumindest teilweisen Entnahme von Bauteilen die Flächenmagazine 204 von der zweiten Transportstrecke 231 entfernt.

Wie aus Figur 2b ersichtlich, erfolgt der Flächenmagazin-Transport lediglich entlang einer Transportrichtung 231a. Damit befindet sich das Flächenmagazin-Zuführmodul 252 vor (stromaufwärts) dem Entnahmebereich 204 und das Flächenmagazin-Entnahmemodul 254 befindet sich nach (stromabwärts) dem Entnahmebereich 232.

Figur 2c zeigt gemäß einem weiteren Ausführungsbeispiel der Erfindung eine Bestückvorrichtung 210. Auch hier erfolgt die Bereitstellung der Flächenmagazine 204 auf automatische Weise. Dazu ist ein Flächenmagazin-Zuführsystem 255 vorgesehen, welches auf einer Seite des Chassis 211 neben der ersten Transportstrecke 221 angeordnet ist. Dies hat den Vorteil, dass in Transportrichtung 221a gesehen relativ zu dem Chassis 211 sowohl linksseitig als auch rechtsseitig noch Platz vorhanden ist, um in Figur 2c nicht dargestellte Bauelement-Zuführsysteme anzuordnen. Derartige Bauelement-Zuführsysteme sind in Figur 1 mit den Bezugszeichen 141 und 146 gekennzeichnet.

Auch die Entnahme von zumindest teilweise entleerten Flächenmagazinen 204 erfolgt mit dem Flächenmagazin-Zuführsystem 255. In diesem Zusammenhang ist klar, dass im Falle der Verwendung eines einzigen Zuführsystems 255 die zweite Transportstrecke 231 einen Flächenmagazin-Transport entlang zweier gegensätzlicher Transportrichtungen ermöglichen muss. Entlang der Transportrichtung 231a erfolgt die Bereitstellung der Flächenmagazine 204 für den Entnahmebereich 232. Entlang der Transportrichtung 231b erfolgt der Abtransport der Flächenmagazine 204 aus dem Entnahmebereich 232.

Das Flächenmagazin-Zuführsystem 255 weist eine Handhabungsvorrichtung 256 auf, mit der die Flächenmagazine 204 automatisch aus einer als Turm ausgebildeten Speichervorrichtung 257 entnommen und auf der zweiten Transportstrecke 231 aufgelegt werden können. Die Handhabungsvorrichtung 256 dient selbstverständlich auch der Entnahme von Flächenmagazinen 204 von der zweiten Transportstrecke 231 und der Einlagerung der Flächenmagazine 204 in den Speicherturm 257.

In dem Speicherturm 257 sind in einer vertikalen Anordnung auf Platz sparende Weise mehrere Flächenmagazine 204 schichtweise übereinander eingelagert. Der Speicherturm 257 ist in eine Mehrzahl von Fächern unterteilt, die jeweils ein Flächenmagazin 204 aufnehmen können. Um auch unterschiedlich hohe Flächenmagazine 204 auf Platz sparende Weise einlagern zu können, sind die Höhen der einzelnen Fächer an die Höhen der verwendeten Flächenmagazine 204 angepasst.

Wie aus Figur 2c ersichtlich, erstreckt sich die zweite Transportstrecke 231 ausgehend von dem Flächenmagazin-Zuführsystem 255 bis über den Entnahmebereich 232 hinaus. Dies hat den Vorteil, dass ein Flächenmagazin 204 auf der zweiten Transportstrecke 231 rechts von dem Entnahmebereich 232 zwischengelagert werden kann. Dies kann beispielsweise dann sinnvoll sein, wenn das betreffende Flächenmagazin 204 nur vorübergehend durch ein anderes Flächenmagazin 204 zum Zwecke der Entnahme von anderen Bauteilen ersetzt wird und danach das betreffende Flächenmagazin 204 zum Zwecke der Entnahme der ursprünglichen Bauteile wieder möglichst schnell in den Entnahmebereich 232 zurück transferiert werden soll.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

Bezugszeichenliste
- 100: Bestücksystem / Bestücklinie
- 102: Bauelementeträger / Leiterplatte
- 104: Flächenmagazin
- 110: erste Bestückvorrichtung / Bestückautomat
- 111: Chassis
- 121: erste Transportstrecke
- 121a: Transportrichtung Bauelementeträger
- 122: erster Bestückbereich
- 125: Flächenpositioniersystem
- 126: Bestückkopf
- 126a: Transportbewegung Bauelemente aus Gurt-Zuführvorrichtungen
- 131: zweite Transportstrecke
- 131a: Transportrichtung Flächenmagazin
- 132: zweiter Bestückbereich / Entnahmebereich
- 135: Flächenpositioniersystem
- 136: Bestückkopf
- 136a: Transportbewegung Bauteile aus Flächenmagazin
- 136b: Transportbewegung Bauelemente aus Gurt-Zuführvorrichtungen
- 141: Bauelement-Zuführsystem
- 142: Bauelement-Zuführvorrichtung
- 146: Bauelement-Zuführsystem
- 147: Bauelement-Zuführvorrichtung
- 160: zweite Bestückvorrichtung / Bestückautomat
- 161: Chassis
- 172: erster Bestückbereich
- 182: zweiter Bestückbereich / Entnahmebereich
- 191: Bauelement-Zuführsystem
- 192: Bauelement-Zuführvorrichtung
- 196: Bauelement-Zuführsystem
- 197: Bauelement-Zuführvorrichtung
- 202: Bauelementeträger / Leiterplatte
- 204: Flächenmagazin
- 210: erste Bestückvorrichtung / Bestückautomat
- 211: Chassis
- 221: erste Transportstrecke
- 221a: Transportrichtung Bauelementeträger
- 231: zweite Transportstrecke
- 231a: Transportrichtung Flächenmagazin
- 231b: Transportrichtung Flächenmagazin
- 232: Entnahmebereich
- 252: Flächenmagazin-Zuführmodul
- 254: Flächenmagazin-Entnahmemodul
- 255: Flächenmagazin-Zuführsystem
- 256: Handhabungsvorrichtung
- 257: Speichervorrichtung / Speicherturm

## Patentansprüche

1. Vorrichtung zum Bestücken von Bauelementeträgern (102, 202) mit Bauteilen, die Vorrichtung (110, 210) aufweisend
• eine erste Transportstrecke (121, 221), eingerichtet zum Transportieren eines ersten Bauelementeträgers (102, 202) in einen ersten Bestückbereich (122),
• eine zweite Transportstrecke (131, 231), eingerichtet zum Transportieren eines zweiten Bauelementeträgers in einen zweiten Bestückbereich (132, 232), und
• einen Bestückkopf (136), welcher derart verfahrbar ist, dass zumindest die beiden Bestückbereiche (122, 132, 232) erreichbar sind, wobei
• die zweite Transportstrecke (131, 231) ferner derart eingerichtet ist, dass in Flächenmagazinen (104, 204) aufbewahrte Bauteile in den zweiten Bestückbereich (132, 232) zuführbar sind.

2. Vorrichtung nach Anspruch 1, wobei
die beiden Transportstrecken (121, 221, 131, 231) zumindest innerhalb der jeweiligen Bestückbereiche (122, 132, 232) parallel zueinander verlaufen.

3. Vorrichtung nach einem der Ansprüche 1 bis 2, wobei
die zweite Transportstrecke (131, 231) ferner derart eingerichtet ist, dass Flächenmagazine (104, 204) wahlweise in einer ersten Transportrichtung (131a, 231a) oder in einer zweiten Transportrichtung (231b) transportierbar sind.

4. Vorrichtung nach einem der Ansprüche 1 bis 3, ferner aufweisend
ein Positioniersystem (135) zum Verfahren des Bestückkopfes (136) .

5. Vorrichtung nach einem der Ansprüche 1 bis 4, ferner aufweisend
zumindest ein Bauelement-Zuführsystem (141, 146), welches seitlich neben den beiden Transportstrecken (121, 131) angeordnet ist.

6. Vorrichtung nach Anspruch 5, ferner aufweisend
einen weiteren Bestückkopf (126), welcher derart verfahrbar ist, dass zumindest der erste Bestückbereich (122) und das Bauelement-Zuführsystem (141) erreichbar sind.

7. Vorrichtung nach einem der Ansprüche 1 bis 6, wobei
die Vorrichtung (210) derart eingerichtet ist, dass Flächenmagazine (204) manuell in die zweite Transportstrecke (231) einlegbar sind und/oder dass
Flächenmagazine (204) manuell von der zweiten Transportstrecke (231) entnehmbar sind.

8. Vorrichtung nach einem der Ansprüche 1 bis 6, ferner aufweisend
• ein mit der zweiten Transportstrecke (231) gekoppeltes Zuführmodul (252) zum automatischen Transferieren von Flächenmagazinen (204) an die zweite Transportstrecke (231) und/oder
• ein mit der zweiten Transportstrecke (231) gekoppeltes Entnahmemodul (254) zum automatischen Entnehmen von Flächenmagazinen (204) von der zweiten Transportstrecke (231).

9. Vorrichtung nach einem der Ansprüche 1 bis 6, ferner aufweisend
• eine Speichervorrichtung (257), welche zum Aufnehmen einer Mehrzahl von Flächenmagazinen (204) eingerichtet ist, und
• eine Handhabungsvorrichtung (256), welche sowohl mit der Speichervorrichtung (257) als auch mit der zweiten Transportstrecke (231) gekoppelt ist.

10. Bestücksystem zum Bestücken von Bauelementeträgern (102) mit Bauteilen, das Bestücksystem (100) aufweisend zumindest eine Vorrichtung (110) nach einem der Ansprüche 1 bis 9.

11. Bestücksystem nach Anspruch 10, ferner aufweisend eine weitere Vorrichtung (160) nach einem der Ansprüche 1 bis 8, wobei die erste Transportstrecke (121) der Vorrichtung (110) und die erste Transportstrecke (121) der weiteren Vorrichtung (160) eine gemeinsame erste Transportstrecke (121) bilden.

12. Bestücksystem nach Anspruch 11, wobei die zweite Transportstrecke (131) der Vorrichtung (110) und die zweite Transportstrecke (131) der weiteren Vorrichtung (160) eine gemeinsame zweite Transportstrecke (131) bilden.

13. Bestücksystem nach Anspruch 11, wobei die zweite Transportstrecke (231) der Vorrichtung (210) und die zweite Transportstrecke der weiteren Vorrichtung voneinander getrennt sind.

14. Verfahren zum Bestücken von Bauelementeträgern (102, 202) mit Bauteilen, welche in einem Flächenmagazin (104, 204) bereitgehalten werden, unter Verwendung einer Vorrichtung (110, 210) nach einem der Ansprüche 1 bis 9, das Verfahren aufweisend
• Transportieren eines Bauelementeträgers (102, 202) in den ersten Bestückbereich (122) mittels der ersten Transportstrecke (121),
• Zuführen des Flächenmagazins (104, 204) in den zweiten Bestückbereich (132, 232) mittels der zweiten Transportstrecke (131, 231), und
• mittels des Bestückkopfes (136)
- Aufnehmen von zumindest einem in dem Flächenmagazin (104) aufbewahrten Bauteil,
- Transportieren des aufgenommenen Bauteils in den ersten Bestückbereich (122) und
- Aufsetzen des Bauteils an eine vorgegebene Position auf dem Bauelementeträger (102).
